Europäisches Patentamt

(19) European Patent Office

Office européen des brevets

(11) Publication number: **0 183 406**

A1

(12) **EUROPEAN PATENT APPLICATION**

(21) Application number: 85308052.1

(22) Date of filing: 06.11.85

(51) Int. Cl.⁴: **H 03 K 19/007**
**B 61 L 1/20**

(30) Priority: 13.11.84 GB 8428658

(43) Date of publication of application:
04.06.86 Bulletin 86/23

(84) Designated Contracting States:
AT BE CH DE FR IT LI NL SE

(71) Applicant: WESTINGHOUSE BRAKE AND SIGNAL
COMPANY LIMITED
Pew Hill
Chippenham Wiltshire(GB)

(72) Inventor: Corrie, John Douglas
12 Queens Close Sutton Benger
Chippenham Wiltshire(GB)

(72) Inventor: Littler, Vincent Howard
6 Down View Derriads Council Estate
Chippenham Wiltshire(GB)

(74) Representative: Bird, Vivian John et al,
PAGE & CO. Temple Gate House
Temple Gate Bristol, BS1 6PL(GB)

(54) **Fail-safe output switching circuit.**

(57) A dynamic output, of the type used in railway signalling
and railway control, in which a vital state represented by an
alternating signal is provided by an output transformer
device (1) driven by two opposing anti-phase current switch-
ing circuits (14,17;15,16). The circuits (14,17;15,16) are
designed to operate in a fail-safe manner; an original vital
signal is employed to modulate a higher frequency which is
rectified to provide a source of current (10, 11 resp.) which is,
in turn, connected to an output device (1) through self-
commutating switching means (14,17; 15,16) to supply
current in one direction and to provide a return path for
current in an opposite direction. The two switching circuits
(14,17; 15,16) are operated by anti-phase modulated signals
so that both must function normally to achieve a full output.

./...

## Fail-Safe Output Switching Circuit

The invention relates to a fail-safe output switching circuit, of the type which is used in railway signalling systems to provide a control signal for safety equipment and which in the event of component failure must not provide an erroneous output.

The invention is particularly useful in connection with switched signals occupying either of two binary states, and in which one of the states represents a vital operating state. The control equipment must be designed such that this vital state can only be attained by correct functioning and no failure state shall be able to reproduce the corresponding output state. In the described embodiment, in the context of railway control and railway signalling, a vital state or vital signal represents an operating condition which, because it directly involves safety, has to be proved correct before it may be implemented.

A conventional output driving stage to provide an alternating output comprises a cross-coupled transistor bridge circuit in which opposite pairs of transistors are switched in anti-phase at the required AC frequency. The switched output is provided via a transformer having an input winding connected between the bridge nodes. In such an arrangement, in the event of a switching transistor failing either open circuit or short circuit the bridge ceases to provide an output. However, if one or more transistors fails to a resistive mode then some current can still flow in the output branch.

According to the present invention there is provided an alternating signal output circuit for providing in a fail-safe manner an alternating output to a load in response to an alternating input signal comprising an output device for connection to a load, first and second bi-directional current switching circuits connected to switch current in alternate directions in the output device, the switching circuits each including a pair of self-commutating switching devices connected in anti-parallel, a first of said pair of devices being operative to switch current for circulation in a first current path including the output device and a second of said pair of devices being operative to switch current for circulation in a second current path including the output device and a source of current which is arranged to be energised by means connected to receive from a modulated signal source a signal modulated in accordance with the alternating input signal, the modulated signal sources being arranged to provide signals modulated in anti-phase such that the corresponding self-commutating switching devices in the switching circuits operate alternately to switch current through the output device at the frequency of the input signal.

Preferably the input impedance of a circuit according to any preceding claim wherein the input impedance of a switching circuit as seen by a modulated signal source relative to the output impedance including the output device is such that, in the event of one of the two switching circuits failing to operate, the current through output device shall be no greater than typically 10% of the current achieved when both circuits operate.

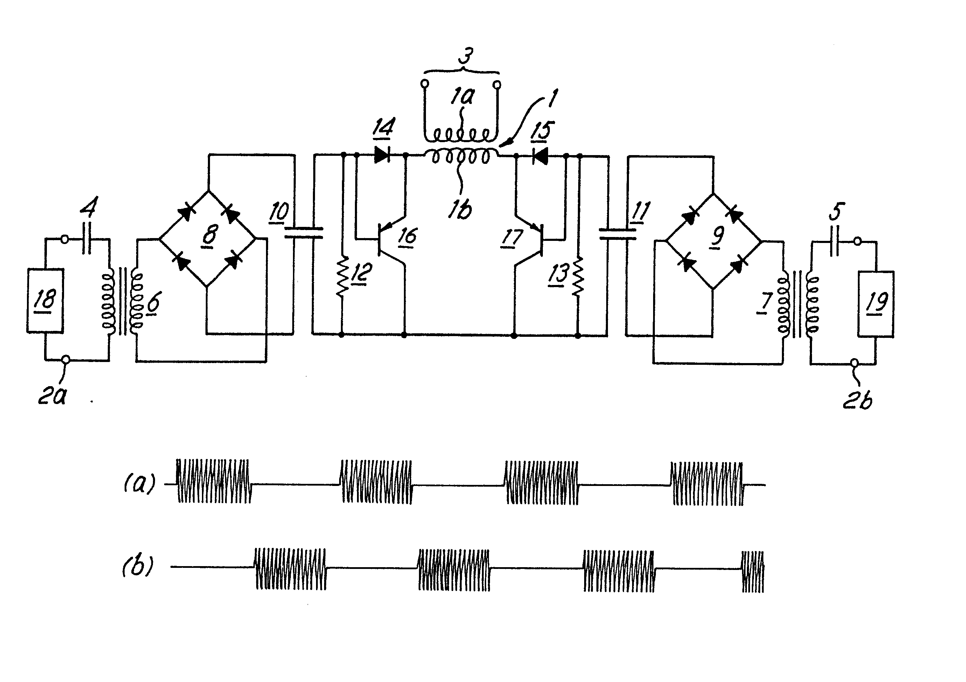

The invention will now be described, by way of example only, with reference to the accompanying drawing which shows a schematic circuit diagram of a preferred arrangement.

0183406

Referring to the drawing there is illustrated a schematic circuit diagram of a fail-safe output switching circuit having a double ended output branch connected to opposite self-commutating switching means. The output branch comprises a transformer 1, the secondary winding 1a of which is connected to output terminals 3, from which the switched output signal is connected to vital safety circuits (not shown) of a railway signalling system. Each end of the primary winding 1b of the transformer 1 is connected to an identical circuit arrangement.

It is to be understood that the description which follows, of the construction of one half of the circuit connected to the output transformer 1, may describe either half of the circuit, and to that end for each item mentioned there are given references for the item in the left half of the drawing and for the corresponding item in the right half of the drawing.

An input signal is received at input terminals 2a, 2b and connected to a capacitive-inductive high-pass filter section comprising series capacitor 4, 5 and transformer 6, 7. The output of the filter is connected to the input terminals of a rectifier bridge 8, 9, and the bridge output nodes are connected to terminals on opposite electrodes of a four terminal capacitor 10, 11. A bleed resistor 12, 13 is connected between the remaining terminals of the capacitor to provide a shunt discharge path for capacitor 10, 11. Transistors 16, 17 are connected in common-collector configuration in combination with diodes 14, 15 respectively to form self-commutating anti-parallel switching devices operative to provide alternating current through the winding 16 of the output device, transformer 1.

- 4 - 0183406

The input terminals 2a and 2b of the two switching circuits are connected respectively to the outputs of pair of amplitude modulated signal generator schematically represented by blocks 18, 19. These generators provide the anti-phase outputs illustrated at (a) and (b) respectively. The alternating input signal upon which the output signal is based forms an amplitude modulating wave form in the generator 18, 19 of a relatively higher frequency wave form, to provide the amplitude modulated carrier signal.

In operation of the circuit described above the input signal may be generated for one of several purposes, for example as a railway track circuit transmitter signal, as a dynamic output control signal, or as a signal representing the operative state of a traffic control device. The relatively higher frequency carrier signal is amplitude modulated by the control signal, and anti-phase outputs of this modulated signal are connected respectively to the input terminals 2a, 2b. The signals pass through the high pass filters 4, 6 and 5, 7 and through the rectifiers 8 and 9 respectively charge capacitors 10 and 11. The voltages on capacitors 10 and 11 tends to follow the voltage wave form of the modulting signal and alternately forward bias diodes 14, 15 and switching transistors 16 and 17. The arrangement being such that when diode 14 is forward biased transistor 17 is commutated into conduction to provide a current path from capacitor 10 through diode 14 and primary winding 1b of transformer 1 returning through transistor 17 in one half cycle; and from capacitor 11 through forward biased diode 15 and primary winding 1b returning through transistor 16 in alternate half cycles. The effect is to produce an alternating current through the primary winding 1b which is in accordance with the original pilot signal.

The resistors 12 and 13 provide a discharge path for the capacitors 10 and 11 respectively when the adjacent transistor 16, 17 is commutated to a conducting state. Four terminal capacitors are preferred to prevent the relatively higher frequency of the modulated signal reaching the output circuit branch containing primary winding 1b in the event that a capacitor connection fails to open circuit.

To achieve full output current drive into the transformer 1 both current switching circuits must function correctly. In the event that one of the circuits ceases to function normally due to component failure some output current will still be provided, however. The level of output produced in such circumstances is generally determined by the ratio of input impedance to output impedance. In the circuit illustrated the output impedance is the total impedance of the transformer input winding 16 including reflected impedance of the secondary winding and load. Similarly the input impedance is the total impedance of the input winding of a transformer 6, 7 including reflected impedances. In the present example these impedances are arranged such that no more than 10% of full normal output can appear across the output device, transformer 1, in the event of any component failure.

Preferably the source impedances, that is of the circuits represented by blocks 18 and 19, are equal in order to produce an evenly balanced output, and also are proof against low resistance so that an input to a switching circuit cannot be effectively short-circuited.

Claims

1. An alternating signal output circuit for providing in a fail-safe manner an alternating output to a load in response to an alternating input signal comprising an output device for connection to a load, first and second bi-directional current switching circuits connected to switch current in alternate directions in the output device, the switching circuits each including a pair of self-commutating switching devices connected in anti-parallel, a first of said pair of devices being operative to switch current for circulation in a first current path including the output device and a second of said pair of devices being operative to switch current for circulation in a second current path including the output device and a source of current which is arranged to be energised by means connected to receive from a modulated signal source a signal modulated in accordance with the alternating input signal, the modulated signal sources being arranged to provide signals modulated in anti-phase such that the corresponding self-commutating switching devices in the switching circuits operate alternately to switch current through the output device at the frequency of the input signal.

2. A circuit according to Claim 1 wherein a modulated signal source is arranged to provide a modulated signal comprising an alternating signal having a frequency relatively higher than the input signal and modulated at the frequency of the input signal.

3. A circuit according to Claim 2 wherein the source of current in a switching circuit comprises a capacitor connected to rectifier means for charging by a modulated signal.

4. A circuit according to Claim 3 wherein a modulated signal source is a.c. coupled to a rectifier means by the use of a transformer.

5. A circuit according to any preceding claim wherein the input impedance of a switching circuit as seen by a modulated signal source relative to the output impedance including the output device is such that, in the event of one of the two switching circuits failing to operate, the current through output device shall be no greater than typically 10% of the current achieved when both circuits operate.

6. A circuit arrangement according to any preceding claim wherein the self-commutating means comprises a transistor switching device in common collector configuration and a forward biased diode connected between base and emitter.

7. A circuit arrangement according to any preceding claim wherein the output circuit branch comprises a first transformer winding inductively coupled with a second transformer winding connected to provide the output.

(a)

(b)

1/1

0183406

## DOCUMENTS CONSIDERED TO BE RELEVANT

| Category | Citation of document with indication. where appropriate, of relevant passages | Relevant to claim | CLASSIFICATION OF THE APPLICATION (Int Cl 4) |
|---|---|---|---|
| A | GB-A- 972 130 (ASSOCIATED ELECTRICAL INDUSTRIES LTD.) * figure, element T2; page 1, line 57 - page 2, line 13 * | 1,7 | H 03 K 19/007 B 61 L 1/20 |
| | ----- | | |
| | | | **TECHNICAL FIELDS SEARCHED (Int Cl 4)** |
| | | | B 61 L 1/20 G 05 B 9/00 G 05 B 9/02 H 03 K 17/66 H 03 K 19/00 H 03 K 19/008 H 03 K 19/007 H 03 K 19/08 |

The present search report has been drawn up for all claims

| Place of search | Date of completion of the search | Examiner |
|---|---|---|
| BERLIN | 29-01-1986 | ARENDT M |